# FASCICULE DE BREVET EUROPEEN

(11) **EP 3 363 973 B1**
(45) Date de publication et mention de la délivrance du brevet: **03.11.2021**
(21) Numéro de dépôt: 18156568.0
(22) Date de dépôt: 13.02.2018
(51) Int. Cl.: E05B 73/00

(54) **RÉGLETTE DE VERROUILLAGE D'UN DISPOSITIF NUMÉRIQUE DANS UN CHÂSSIS**
VERRIEGELUNGSMECHANISMUS FÜR EIN DIGITALES GERÄT IN EINEM CHASSIS
LOCKING MECHANISM FOR A DIGITAL DEVICE IN A CHASSIS

(30) Priorité: 20.02.2017 FR 1751333
(43) Date de publication de la demande: 22.08.2018
(73) Titulaire: INGENICO GROUP, 75015 Paris (FR)
(72) Inventeur: SOUBIRANE, Alain, 26500 Bourg-Les-Valences (FR); ALLIROT, Richard, 38700 Corenc (FR); COCHET, Damien, 26300 Barbieres (FR)
(74) Mandataire: Vidon Brevets & Stratégie

(56) Documents cités:
- EP-A1- 2 721 232
- US-A1- 2011 080 137
- US-A1- 2016 224 065
- US-B1- 8 418 514

## Description

### 1. Domaine de l'invention

Le domaine de l'invention est celui des dispositifs de sécurisation de dispositifs numériques. Plus particulièrement, l'invention se rapporte aux dispositifs antivol permettant de sécuriser une tablette tactile ou un smartphone au sein d'un châssis.

### 2. Art Antérieur

Le marché des dispositifs numériques portables (smartphones, tablettes, etc.) est en plein essor. Au delà de l'engouement marqué du grand public pour ces appareils, le monde professionnel a également rapidement pris conscience des possibilités multiples offertes par ces outils très polyvalents. Les tablettes tactiles ont par exemple fait l'objet d'une attention toute particulière de la part des gérants de points de ventes, et de nouveaux usages se sont développés autour de ces appareils relativement bon marché, de plus en plus puissants, connectés, peu encombrants et disposant d'un écran de taille confortable. De nombreuses applications spécifiques ont ainsi été développées, pour répondre à différents besoins. Certaines applications orientées vers le commerçant ont ainsi vu le jour. Des solutions visant à remplacer les caisses enregistreuses traditionnelles par des tablettes tactiles intégrant un logiciel de caisse adapté ont par exemple émergé. Pour le gérant du point de vente, ces solutions offrent de nombreux avantages par rapport aux caisses enregistreuses traditionnelles : elles sont moins coûteuses, plus compactes, et le logiciel de caisse embarqué peut être facilement mis à jour lorsque de nouvelles fonctionnalités sont disponibles. Elles offrent de plus davantage de flexibilité au commerçant, en lui permettant par exemple de privilégier une solution basée sur un modèle de tablette tactile qui lui est familier et qu'il connait bien pour l'utiliser dans d'autres contextes. Par ailleurs, la tablette tactile, dispositif mobile et connecté par nature, ouvre de nouvelles opportunités de travail : cette caisse enregistreuse d'un nouveau genre n'est plus nécessairement attachée à demeure au lieu de commerce, et le commerçant peut par exemple facilement l'emmener avec lui à son domicile ou chez son comptable pour réaliser divers bilans.

Pour accompagner ces nouveaux usages, il a été nécessaire de proposer des dispositifs permettant de maintenir les dispositifs numériques utilisés dans des positions adaptées à leur utilisation. Ainsi, des socles spécialement conçus pour accueillir ces dispositifs numériques ont été développés et commercialisés. L'utilisation de ces dispositifs numériques par nature portable dans des lieux très fréquentés tels que des points de vente a par ailleurs entrainé un besoin de sécurisation de ces appareils : il s'agit non seulement de les protéger physiquement mais également de se prémunir de leur vol par des personnes mal intentionnées. Une telle sécurisation est par exemple mise en œuvre au moyen d'un système classique de clé et de verrou permettant de fermer une armature, également appelée châssis, dans laquelle le dispositif numérique est maintenu. De nombreux systèmes de châssis ont donc été proposés, avec pour objectif de maintenir d'une part et de sécuriser d'autre part le dispositif numérique qui y est installé.

Cependant, les utilisateurs de ces châssis n'ont pas nécessairement les mêmes exigences en termes de sécurisation : tandis que certains utilisateurs recherchent avant tout une simple solution de maintien, qui permet une extraction relativement facile et rapide du dispositif numérique, d'autres ont besoin d'un niveau de sécurisation contre le vol plus élevé (par exemple parce que le dispositif numérique n'est pas sous surveillance constante de la part du commerçant). Aussi, l'utilisateur est généralement amené à choisir dès l'origine un type de châssis bien spécifique, qui répond à des besoins initiaux. Cette solution est cependant relativement figée : si les besoins de l'utilisateur en terme de sécurisation évoluent (par exemple suite à une configuration de local différente après un déménagement, ou à une hausse de fréquentation du commerce), il n'a souvent pas d'autre choix que de racheter un nouveau châssis mieux adapté à ses nouveaux besoins, ce qui peut s'avérer onéreux. Ceci impose aussi des contraintes au fabricant du châssis, qui doit développer et maintenir une gamme de châssis différents afin d'être en mesure de proposer à ses clients des solutions adaptées à chaque situation. Les coûts associés au maintien d'une gamme comprenant plusieurs types de châssis sont importants, et il serait intéressant pour le fabricant de bénéficier d'une solution permettant de réaliser des économies d'échelle.

Le document US 2011/080137 A1 peut être considéré comme représentant l'état de la technique le plus proche.

Il existe donc un besoin d'une solution plus modulaire, qui permette à partir d'un même châssis d'adapter le niveau de sécurisation du dispositif numérique qui y est installé.

### 3. Résumé de l'invention

La présente technique permet de résoudre en partie les problèmes posés par l'art antérieur. La présente technique se rapporte en effet à une réglette de verrouillage selon la revendication 1 destinée à verrouiller un dispositif numérique préalablement inséré dans un châssis. La réglette comprend une face interne de réception d'au moins une portion du dispositif numérique et une face externe dite de verrouillage. Elle comprend par ailleurs :
- des moyens d'assemblage sur ledit châssis ;
- des moyens de retenue dudit dispositif numérique ;
- au moins une unité de verrouillage, comprenant des moyens de verrouillage de la réglette audit châssis.

Ainsi, la réglette de verrouillage est un accessoire astucieux apte à être assemblé sur un châssis (pouvant être utilisé par ailleurs de manière autonome), de manière à renforcer la protection, contre le vol, du dispositif numérique qui est installé au sein du châssis. Les moyens de retenue retiennent le dispositif numérique dans le châssis, une fois la réglette de verrouillage assemblée sur le châssis, et l'unité de verrouillage empêche le démontage de la réglette de verrouillage (c'est à dire son désassemblage du châssis) par une personne non habilitée. Ainsi, ces trois éléments principaux de la réglette de verrouillage - moyens d'assemblage, moyens de retenue et unité de verrouillage - coopèrent pour s'opposer au retrait non autorisé d'un dispositif numérique préalablement installé dans le châssis. De cette manière, l'utilisateur dispose d'un accessoire lui offrant la possibilité de renforcer le niveau de sécurisation d'un châssis déjà en sa possession, et qu'il n'a donc pas besoin de remplacer.

Dans un mode de réalisation particulier, les moyens de verrouillage comprennent un ergot de verrouillage mobile disposant d'une extrémité de verrouillage, l'ergot de verrouillage étant mobile entre deux positions :
- une position de déverrouillage, dans laquelle ledit ergot est au moins partiellement disposé au sein d'un logement d'accueil aménagé dans ladite unité de verrouillage ;
- une position de verrouillage, dans laquelle ladite extrémité de verrouillage dudit ergot fait saillie vers l'extérieur de la face interne de ladite réglette.

Ainsi, l'ergot de verrouillage peut être assimilé à un verrou rétractile.

Dans sa position de déverrouillage, l'ergot est rétracté au sein de son logement dans l'unité de verrouillage, et la réglette de verrouillage peut alors être assemblée ou désassemblée du châssis sans que l'ergot en question n'entrave cette opération.

A l'inverse, dans sa position de verrouillage, l'extrémité de verrouillage de l'ergot de verrouillage fait saillie vers l'extérieur de la face interne de l'unité de verrouillage, de manière à venir s'engager dans un orifice de verrouillage existant sur le châssis. L'ergot de verrouillage s'oppose alors au désassemblage de la réglette de verrouillage et du châssis, et la réglette est donc verrouillée au châssis et empêche l'extraction du dispositif numérique.

Dans un mode de réalisation particulier, lesdits moyens de verrouillage comprennent des moyens d'entrainement dudit ergot de verrouillage mobile de ladite position de verrouillage à ladite position de déverrouillage et inversement.

Ainsi, un utilisateur habilité a la possibilité, éventuellement au moyen d'un outil spécifique, d'actionner ces moyens d'entrainement de manière à verrouiller ou déverrouiller la réglette.

Dans un mode de réalisation particulier, l'extrémité de verrouillage de l'ergot de verrouillage mobile prend la forme d'un crochet en « T ».

De cette manière, la réglette de verrouillage est rendue compatible avec un châssis existant qui disposerait déjà d'une fente de verrouillage dans un format standard, telle que par exemple une encoche de sécurité de type Kensington™.

Dans un mode de réalisation particulier, l'unité de verrouillage comprend un point d'ancrage.

De cette manière, la réglette de verrouillage peut également être sécurisée contre le vol, en utilisant ce point d'ancrage pour fixer la réglette de verrouillage à un élément fixe du bâti au moyen d'un câble de sécurité par exemple. Ce point d'ancrage fait donc office de moyen de sur-verrouillage, dans la mesure où il autorise un verrouillage complémentaire au verrouillage de la réglette au châssis, permettant ainsi de sécuriser l'ensemble formé par un dispositif numérique tactile retenu dans son châssis verrouillé par une réglette de verrouillage.

Dans un mode de réalisation particulier, ledit point d'ancrage prend la forme d'une fente de verrouillage adaptée pour accueillir un verrou idoine.

Ainsi, le sur-verrouillage peut être réalisé en utilisant un type de verrou largement reconnu et couramment disponible dans le commerce.

Dans un mode de réalisation particulier, les moyens d'entrainement de l'ergot de verrouillage mobile :
- font saillie vers l'extérieur de la face externe de la réglette de verrouillage, au niveau de l'unité de verrouillage, dans ladite position de déverrouillage ;
- sont disposés au sein d'un logement d'accueil aménagé dans l'unité de verrouillage, dans ladite position de verrouillage.

De cette manière, l'utilisateur est en mesure d'évaluer très rapidement, d'un simple coup d'œil, si la réglette de verrouillage est verrouillée (les moyens d'entrainement sont alors rétractés dans leur logement) ou déverrouillée (les moyens d'entrainement sont alors sortis de leur logement et font saillie vers l'extérieur de l'unité de verrouillage). Ainsi, le risque que l'utilisateur imagine la réglette verrouillée alors qu'elle ne l'est pas en réalité est limité.

Dans encore un mode de réalisation particulier, en position de verrouillage, lesdits moyens d'entrainement sont au moins partiellement recouverts par un dispositif de verrouillage qui prendrait place dans ladite fente de verrouillage.

De cette manière, la protection du dispositif numérique est encore renforcée car les moyens d'entrainement de l'ergot de verrouillage ne peuvent être actionnés tant que le dispositif de verrouillage fixé au point d'ancrage n'a pas été retiré.

Dans un mode de réalisation particulier, lesdits moyens d'entrainement et ladite fente de verrouillage sont par exemple disposés sur une même face de ladite unité de verrouillage, et distants l'un par rapport à l'autre d'au maximum neuf millimètres.

De cette manière, lorsque la réglette est verrouillée au châssis (l'ergot mobile étant alors dans sa position verrouillée) et lorsqu'un sur-verrouillage au moyen d'un verrou du commerce de dimension standard (en particulier un verrou Kensington™) est mis en œuvre, le corps de ce verrou vient recouvrir au moins en partie les moyens d'entrainement de l'ergot de verrouillage. Le corps du verrou s'oppose alors à tout actionnement des moyens d'entrainement de l'ergot de verrouillage mobile. Ainsi, ce dernier ne peut être déverrouillé tant que le sur-verrouillage n'a pas été retiré.

De cette manière, les moyens d'entrainement de l'ergot de verrouillage mobile empêchent le sur-verrouillage tant que ledit ergot n'est pas dans sa position verrouillée.

Selon un autre aspect, il est également décrit un système de verrouillage d'un dispositif numérique, qui comprend :
- un châssis adapté pour recevoir ledit dispositif numérique, ledit châssis comprenant au moins un orifice de verrouillage ;
- une réglette de verrouillage telle que présentée précédemment, les moyens de verrouillage de ladite réglette étant configurés pour permettre le verrouillage de ladite réglette au châssis, au niveau de l'orifice de verrouillage dudit châssis, lorsque la réglette est assemblée au châssis.

Selon un mode de réalisation particulier de ce système, le châssis comprend en outre :
- au moins un moyen de maintien mobile du dispositif numérique ;
- des moyens de blocage dudit au moins un moyen de maintien mobile dans une position prédéterminée, lesdits moyens de blocages étant actifs lorsqu'un ergot de verrouillage est inséré dans l'orifice de verrouillage dudit châssis.

Ainsi, le verrouillage d'une réglette de verrouillage sur le châssis permet, en plus de la mise en œuvre de moyens de sécurisation propres à la réglette, d'activer des moyens de sécurisation propres au châssis.

Selon encore un autre aspect, on décrit également un procédé de verrouillage d'un dispositif numérique au sein d'un châssis. Ce procédé comprend les étapes suivantes :
- une étape d'insertion du dispositif numérique au sein du châssis ;
- une étape d'assemblage, audit châssis, d'une réglette de verrouillage telle que présentée précédemment ;
- une étape de verrouillage de ladite réglette audit châssis, comprenant une étape d'actionnement des moyens d'entrainement de l'ergot de verrouillage mobile de la réglette, au moyen d'un outil spécifique.

Dans un mode de réalisation particulier, ledit procédé comprend en outre, postérieurement à l'étape de verrouillage de ladite réglette audit châssis, une étape de sur-verrouillage de la réglette, comprenant une étape de fixation d'un verrou au point d'ancrage présent sur l'unité de verrouillage de la réglette.

Les différents modes de réalisation mentionnés ci-dessus sont combinables entre eux pour la mise en œuvre de l'invention.

### 4. Figures

D'autres caractéristiques et avantages de l'invention apparaîtront plus clairement à la lecture de la description suivante d'un mode de réalisation préférentiel, donné à titre de simple exemple illustratif et non limitatif, et des dessins annexés, parmi lesquels :
- la figure 1 présente une vue en perspective d'une réglette de verrouillage dans un mode de réalisation particulier ;
- la figure 2 présente une vue de devant d'un châssis sur lequel est assemblée une réglette de verrouillage selon un mode de réalisation particulier ;
- la figure 3 montre une vue de derrière d'un châssis présenté seul, sans réglette de verrouillage, dans un mode de réalisation ;
- la figure 4 présente une vue de derrière d'un châssis sur lequel est assemblée une réglette de verrouillage selon un mode de réalisation particulier ;
- les figures 5a, 5b et 5c détaillent en gros plan l'unité de verrouillage d'une réglette de verrouillage, respectivement dans une position de déverrouillage (figure 5a), en cours de verrouillage (figure 5b), et de verrouillage (figure 5c) de la réglette, dans un mode de réalisation particulier ;
- la figure 6 illustre un exemple de mise en œuvre d'un sur-verrouillage d'une réglette de verrouillage préalablement verrouillée sur un châssis (vue partielle), dans un mode de réalisation particulier ;
- la figure 7 montre une vue de devant d'un châssis sur lequel est assemblé une réglette de verrouillage selon un mode de réalisation particulier, le châssis étant présenté sans sa façade avant ;
- la figure 8 illustre les principales étapes d'un procédé de verrouillage d'un dispositif numérique au sein d'un châssis, dans un mode de réalisation particulier.

### 5. Description détaillée

### 5.1. Principe général

Le principe général de l'invention consiste à proposer une réglette de verrouillage destinée à verrouiller un dispositif numérique au sein d'un châssis. Une telle réglette de verrouillage permet d'accroitre la sécurisation contre le vol du dispositif numérique préalablement installé dans le châssis. Les termes « verrouillage » ou « sécurisation » utilisés dans le présent document font donc référence au fait que des moyens sont mis en œuvre afin d'empêcher, ou à tout le moins à rendre long et difficile, toute extraction, par une personne non habilitée, d'un dispositif numérique hors du châssis au sein duquel il est installé. Par extension, ces termes seront également utilisés pour faire référence aux moyens mis en œuvre pour se prémunir d'un vol de l'ensemble formé par le châssis et le dispositif numérique qui y est installé, ou de l'ensemble formé par le châssis, la réglette de verrouillage qui y est assemblée, et le dispositif numérique qui y est installé. Le dispositif numérique en question est quelconque : il peut notamment prendre la forme d'une tablette ou un smartphone.

Selon la technique proposée, la réglette de verrouillage est indépendante du châssis : elle ne fait pas partie intégrante du châssis. Le châssis peut en effet être utilisé seul, sans réglette, et assurer ainsi un premier niveau de sécurisation du dispositif numérique qui y est installé. La réglette de verrouillage prend donc la forme d'un accessoire susceptible d'être couplé au châssis afin de renforcer la protection offerte par l'ensemble formé du châssis et de la réglette. Sur toutes les figures du présent document, les éléments et étapes identiques sont désignés par une même référence numérique. Bien que la présente technique vise à renforcer la sécurité, contre le vol, d'un dispositif numérique, ce dernier n'est jamais représenté sur les figures, afin de ne pas les surcharger et de rendre visible certains éléments utiles à la compréhension de la solution décrite.

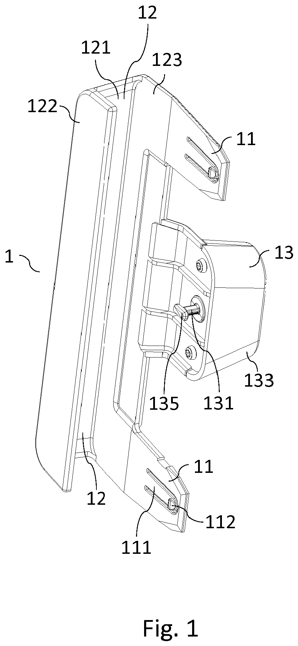

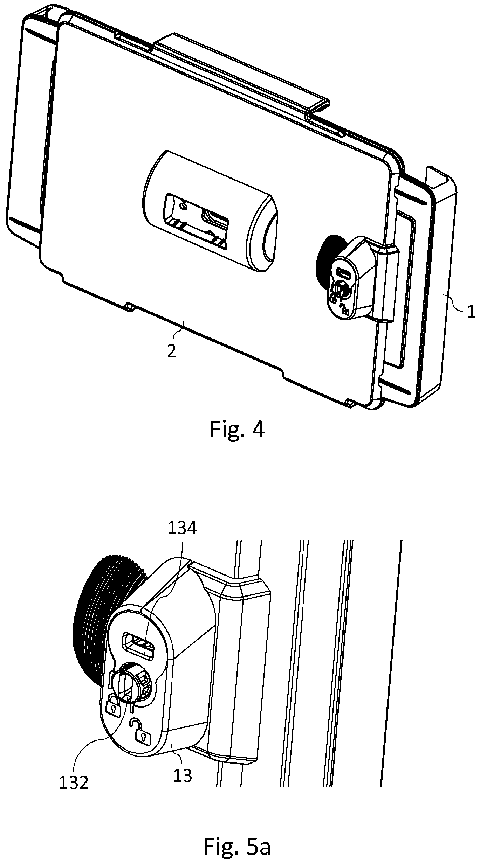

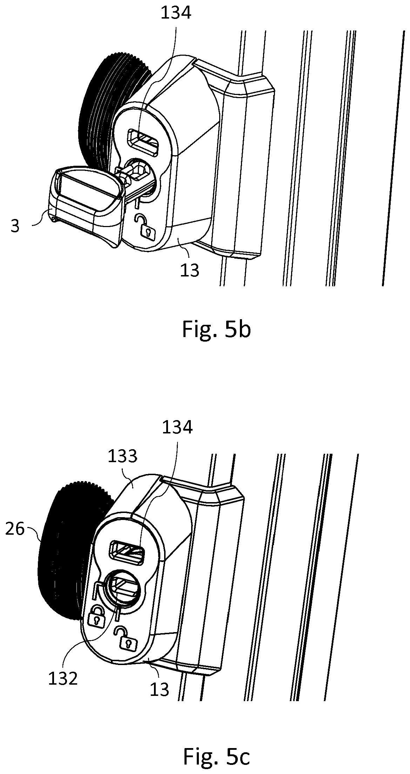

On présente, en relation avec la **figure 1****,** un exemple de réglette de verrouillage 1 destinée à verrouiller un dispositif numérique tactile dans un châssis, dans un mode de réalisation particulier. La figure 1 montre plus particulièrement la face interne de la réglette de verrouillage 1, c'est à dire la face de réception d'au moins une portion du dispositif numérique. La face externe de cette réglette 1 - dite face externe de verrouillage dans la mesure où elle comprend les moyens permettant à un utilisateur habilité de mettre en œuvre son verrouillage au châssis - sera présentée ultérieurement, notamment en relation avec les figures 5a, 5b et 5c.

Selon le principe général de l'invention, la réglette de verrouillage 1 comprend :
- des moyens d'assemblage 11 de la réglette sur le châssis ;
- des moyens de retenue 12 du dispositif numérique ;
- au moins une unité de verrouillage 13, comprenant des moyens de verrouillage (131, 132) de la réglette audit châssis.

Ces différents éléments seront présentés plus en détails ultérieurement, lors de la description d'un mode de réalisation spécifique de l'invention.

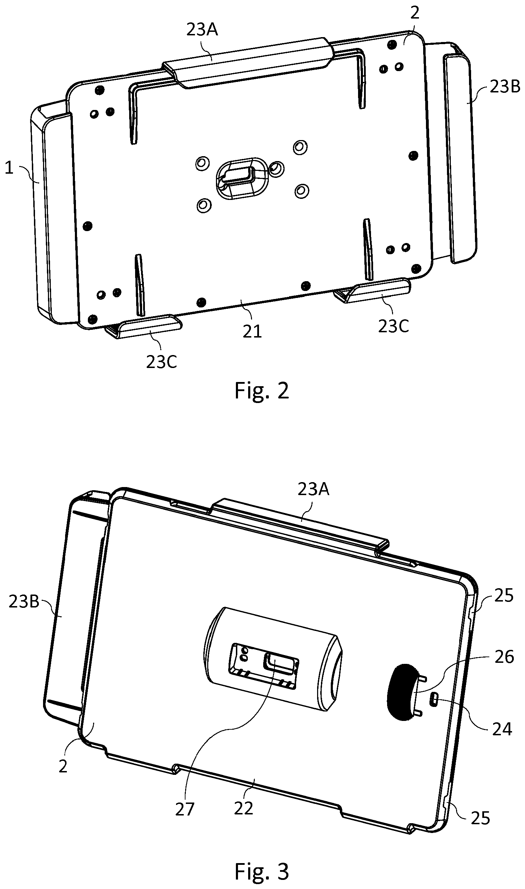

Comme décrit précédemment, la réglette de verrouillage vise à être utilisée conjointement à un châssis. Par « châssis », on entend ici un dispositif adapté pour accueillir et maintenir un dispositif numérique en son sein. Un tel châssis est généralement conçu de manière à permettre à l'utilisateur d'accéder à tout ou partie des fonctionnalités offertes par le dispositif numérique. Par exemple, l'écran du dispositif numérique installé dans le châssis, et éventuellement certains moyens de contrôle du dispositif numérique, restent généralement accessibles. On présente, en relation avec les **figures 2** à **4****,** un exemple d'un tel châssis 2. Sur la figure 2, le châssis est vu de devant, et une réglette de verrouillage 1 y est montée. Les figures 3 et 4 montrent quant à elles le châssis vu de derrière, respectivement sans (figure 3) et avec (figure 4) une réglette de verrouillage 1.

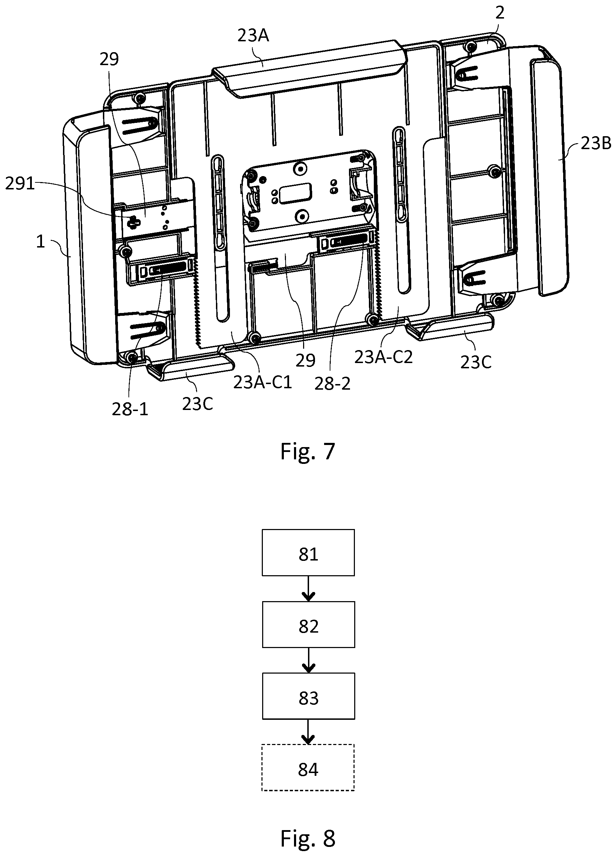

Le châssis 2 présente une forme globalement parallélépipédique rectangle. Il comprend une façade avant 21 et une façade arrière 22. Ces deux façades ont une forme globalement rectangulaire, et sont de dimensions sensiblement équivalentes. Elles sont assemblées entre-elles de manière à former le corps du châssis 2. La face externe de la façade avant 21 fait office de surface d'accueil du dispositif numérique : c'est sur cette face que repose au moins en partie le dos du dispositif numérique lorsque ce dernier est installé dans le châssis. Le châssis 2 comprend également des moyens de maintien du dispositif numérique. Dans le mode de réalisation particulier du châssis présenté en relation avec les figures 2 à 4, ces moyens de maintien prennent la forme de rainures (23A, 23B, 23C) disposées sur trois côtés du châssis. Ces rainures sont destinées à accueillir chacune un côté du dispositif numérique installé dans le châssis, afin d'en assurer le maintien. En l'absence de réglette de verrouillage montée sur le châssis, le quatrième côté du châssis est laissé libre. En d'autres termes, ce quatrième côté ne comprend pas de rainure propre au châssis : il fait office de côté ouvert, libre, par lequel le dispositif numérique peut être inséré au sein du châssis via un mouvement de translation. Plus particulièrement, lors de cette insertion, les rainures 23A et 23C placées en vis-à-vis de part et d'autre du châssis font office de rainures de guidage du dispositif numérique, tandis que la rainure 23B placée en vis-à-vis du côté libre fait office de rainure de butée de fin de course. A ce stade, il convient de noter que le châssis 2, considéré seul et sans réglette de verrouillage, constitue bien un dispositif de maintien à part entière d'un dispositif numérique : une fois inséré dans un tel châssis 2, le dos du dispositif numérique repose sur la face externe de la façade avant 21, sa base repose sur le fond des rainures 23C ou 23B (selon qu'il soit utilisé en mode paysage ou portrait), et les parois avant des rainures (notamment celles de la rainure 23A) empêchent tout basculement du dispositif numérique vers l'avant. Le châssis 2 peut donc être utilisé de manière autonome, sans que la réglette de verrouillage 1 y soit assemblée. Outre le maintien du dispositif numérique, le châssis seul peut également offrir un premier niveau de sécurisation du dispositif numérique qui y est installé. La rainure 23A peut par exemple être une rainure mobile, dont la position peut être ajustée et bloquée postérieurement à l'installation du dispositif numérique, de manière à ce que les rainures 23A et 23C, en vis-à-vis, l'enserrent. Ainsi, tant que la position de la rainure 23A est maintenue bloquée, il devient difficile d'extraire le dispositif numérique par le côté libre du châssis, les forces de frottement exercées par les rainures sur le dispositif numérique s'opposant à la translation nécessaire à son extraction. Cette difficulté peut encore être accrue lorsque le fond des rainures en question comprend un grip, par exemple un grip en caoutchouc, augmentant encore ces forces de frottement. Le déblocage de la position de la rainure 23A peut par exemple être effectué par un utilisateur habilité, via l'actionnement de moyens de déblocage matérialisés par le bouton 26 visible sur la figure 3 par exemple. Des moyens permettant d'empêcher une personne non habilitée d'actionner ce bouton 26 seront décrits ultérieurement dans le document, en relation avec la figure 7.

Le châssis 2 comprend également généralement un point d'ancrage, typiquement un orifice de verrouillage adapté pour recevoir un verrou idoine. Un tel orifice de verrouillage 24 est notamment visible sur la figure 3 qui présente une vue arrière du châssis seul. Cet orifice de verrouillage 24 est utilisé pour sécuriser contre le vol l'ensemble formé par le châssis 2 et le dispositif numérique qui y est installé. Il permet d'attacher le châssis 2 à un élément fixe du bâti, au moyen d'un câble de sécurité muni d'un verrou par exemple. Cet orifice de verrouillage 24 peut notamment prendre la forme d'une encoche de sécurité de type Kensington™. Cette sécurisation supplémentaire via l'orifice de verrouillage 24 peut être mise en œuvre alternativement ou en complément de la fixation du châssis 2 à un socle, éventuellement opérée via des moyens de fixation à un socle dédiés 27, présents sur le châssis.

Il ressort de cette description que le châssis présenté est suffisant à lui seul pour assurer le maintien et un premier niveau de sécurisation d'un dispositif numérique qui y est installé. Ce premier niveau de sécurisation peut néanmoins s'avérer insuffisant dans certaines configurations, et la réglette de verrouillage de la technique proposée vise alors à offrir un moyen d'augmenter le niveau de sécurisation sans avoir à remplacer le châssis en question.

Par la suite, on décrit un mode de réalisation spécifique d'une réglette de verrouillage se rapportant au principe général qui vient d'être décrit.

### 5.2. Description détaillée d'un mode de réalisation

Comme décrit précédemment, une réglette de verrouillage telle que proposée vise à être utilisée en complément d'un châssis. La réglette de verrouillage ne fait cependant pas partie du châssis : ce dernier est autonome et peut même, dans certains modes de réalisation, déjà intégrer ses propres moyens de sécurisation d'un dispositif numérique qui y est installé, en complément de moyens de maintien. A ce titre, la réglette de verrouillage peut être considérée comme un accessoire susceptible d'être assemblé sur un châssis afin d'accroitre le niveau de sécurisation offert par ce châssis. Il s'agit donc, par l'assemblage et le verrouillage de cette réglette de verrouillage sur le châssis, de rendre encore plus difficile la mise en œuvre de toute tentative de vol du dispositif numérique par une personne mal intentionnée.

On décrit maintenant de manière détaillée les principaux éléments d'une réglette de verrouillage dans le mode de réalisation particulier illustré sur les figures 1 à 7, étant entendu que ce mode de réalisation ne limite en rien la portée de l'invention. Plus particulièrement, dans d'autres modes de réalisation de l'invention, les moyens d'assemblage, de retenue et de verrouillage de la réglette de verrouillage ne sont pas limités à ceux décrits par la suite.

### Moyens d'assemblage

Dans ce mode de réalisation particulier, les moyens d'assemblage de la réglette de verrouillage 1 sur le châssis prennent la forme de languettes d'assemblage 11, visibles par exemple sur la figure 1. Le montage de la réglette 1 sur le châssis est réalisé en engageant ces languettes d'assemblage 11 dans des logements complémentaires du châssis (comme montré sur la figure 4 notamment). Les orifices d'entrée 25 de ces logements sont visibles sur la figure 3. Ces orifices sont situés au niveau du côté libre du châssis, c'est à dire sur le côté dépourvu de moyens de maintien propres au châssis. Dans ce mode de réalisation, la réglette de verrouillage est en effet destinée à venir fermer, après installation du dispositif numérique dans le châssis, le côté libre du châssis habituellement utilisé pour insérer ou retirer le dispositif numérique.

Selon une caractéristique particulière, les languettes d'assemblage 11 peuvent comprendre des moyens de clipsage au châssis. Sur l'exemple de la figure 1, chaque languette d'assemblage 11 comprend ainsi une lamelle prédécoupée 111 au bout de laquelle une protubérance fait office d'ergot de clipsage 112. Lorsque les languettes d'assemblage 11 sont insérées dans leur logements complémentaires, les lamelles prédécoupées 111 subissent une légère déformation élastique, jusqu'à ce que les ergots de clipsage 112 se trouvent en regard de cavités complémentaires dans le châssis et y prennent place sous l'action de la force de rappel élastique. Le clipsage est ainsi assuré. Le retrait de la réglette de verrouillage peut être effectué « à force » : une traction suffisante sur la réglette suffit à débloquer les ergots de clipsage. Le rôle premier de ces ergots de clipsage 112 n'est pas de verrouiller la réglette au châssis : ils servent avant tout à assurer un positionnement correct de la réglette de verrouillage vis-à-vis du châssis, afin de permettre son verrouillage ultérieur. Un tel positionnement correct consiste notamment à aligner un orifice de sortie d'un ergot de verrouillage 131 (qui sera décrit ultérieurement) de l'unité de verrouillage 13 avec l'orifice de verrouillage 24 présent à l'arrière du châssis.

Selon diverses autres caractéristiques particulières, les languettes d'assemblage 11 et les logements complémentaires du châssis sont conformés et dimensionnés de manière à éviter tout montage de travers (grâce à des moyens de guidage) ou à l'envers (grâce à des moyens jouant le rôle de détrompeurs). Par exemple, la forme du profil des languettes d'assemblage 11 et la forme des orifices d'entrée complémentaires 25 du châssis sont conçues de manière à ce qu'un montage « à l'envers » de la réglette de verrouillage, qui serait susceptible d'endommager la réglette et/ou le châssis, ne soit pas possible.

Dans le mode de réalisation illustré, les languettes d'assemblage 11 s'étendent dans un plan qui coïncide sensiblement avec un plan de jonction des façades avant et arrière du châssis, lorsque la réglette de verrouillage 1 est assemblée sur le châssis 2 (comme visible sur la figure 4). Il est intéressant de noter qu'un tel plan délimite deux espaces fonctionnels distincts de la réglette de verrouillage 1 : un espace avant, dans lequel se situent les moyens de retenue 12 du dispositif numérique, et un espace arrière, dans lequel se situe l'unité de verrouillage 13 comprenant les moyens de verrouillage de la réglette au châssis.

### Moyens de retenue

La réglette de verrouillage comprend également des moyens de retenue du dispositif numérique préalablement inséré dans le châssis. Dans le mode de réalisation particulier illustré par exemple sur la figure 1, ces moyens de retenue prennent la forme d'une rainure 12 dans laquelle un des côtés du dispositif numérique vient s'engager lorsque la réglette de verrouillage est montée sur le châssis (les autres côtés de la tablette étant par exemple déjà maintenus par les moyens de maintien 23A, 23B et 23C du châssis). Plus précisément, la rainure 12 a une forme en « U » : elle comprend un fond 121, et deux parois latérales (une paroi avant 122 et une paroi arrière 123). Le fond 121 sert de butée au côté de la tablette engagé dans la rainure 12. A ce titre, c'est lui qui s'oppose principalement au retrait du dispositif numérique du châssis, une fois la réglette de verrouillage assemblée.

D'autres formes de moyens de retenue sont évidemment envisageables dans le cadre de la présente invention, dans d'autres modes de réalisation. Le choix de ces formes peut notamment être guidé par la forme et le nombre des moyens de maintien déjà présents sur le châssis. L'objectif étant que l'action conjointe des moyens de maintien du châssis d'une part et des moyens de retenue de la réglette de verrouillage d'autre part supprime tout degré de liberté du dispositif numérique qui serait suffisant pour permettre son extraction du châssis. Par exemple, les moyens de retenue d'une réglette de verrouillage destinée à être utilisée avec un châssis tel que celui représenté en figure 2 pourraient se présenter sous une forme en « L » (forme qui correspondrait à celle de la rainure 12 amputée de sa paroi avant 122). En effet, les moyens de maintien (23A, 23B, 23C) propres au châssis empêchent déjà par eux-mêmes toute extraction « par l'avant » du dispositif numérique, et la présence d'une paroi avant 122 sur la réglette de verrouillage n'est à ce titre pas absolument nécessaire pour cette configuration particulière de châssis.

### Unité de verrouillage

Outre les moyens d'assemblage sur le châssis et les moyens de retenue du dispositif numérique, la réglette de verrouillage comprend au moins une unité de verrouillage, destinée à verrouiller la fixation de la réglette sur le châssis. A cet effet, l'unité de verrouillage comprend des moyens de verrouillage de la réglette au châssis. L'unité de verrouillage vise donc à empêcher le démontage de la réglette de verrouillage (c'est à dire son désassemblage du châssis) par une personne non habilitée. On rappelle par ailleurs que les moyens de retenue retiennent le dispositif numérique dans le châssis, une fois la réglette de verrouillage assemblée sur le châssis. Ainsi, les trois éléments principaux de la réglette de verrouillage - moyens d'assemblage, moyens de retenue et unité de verrouillage - coopèrent pour s'opposer au retrait non autorisé d'un dispositif numérique préalablement installé dans le châssis.

La figure 1 montre la réglette de verrouillage 1 seule, non assemblée sur un châssis, face interne visible (cette face interne correspond à la face de réception d'au moins une portion du dispositif numérique). On distingue donc également sur cette figure la face interne de l'unité de verrouillage 13, amenée à faire face au dos du châssis une fois la réglette assemblée sur le châssis. La face externe de l'unité de verrouillage 13 est quant à elle visible sur les figures **5a****,** **5b et 5c**, qui montrent chacune une vue détaillée de l'unité de verrouillage 13 de la réglette assemblée sur un châssis, respectivement dans une position de déverrouillage (figure 5a), en cours de verrouillage (figure 5b), et de verrouillage (figure 5c) de la réglette.

Les moyens de verrouillage de l'unité de verrouillage 13 comprennent notamment un ergot de verrouillage 131. Cet ergot de verrouillage 131, de préférence en métal, est formé d'une tige dans le prolongement de laquelle se trouve une extrémité de verrouillage 135. Cet ergot de verrouillage 131 est mobile entre deux positions : une position de verrouillage et une position de déverrouillage.

Dans sa position de déverrouillage, l'ergot de verrouillage 131 est au moins partiellement disposé au sein d'un logement d'accueil aménagé dans l'unité de verrouillage 13. Cette position autorise l'assemblage et le désassemblage de la réglette de verrouillage au châssis. En effet, dans cette position, l'ergot de verrouillage 131 est suffisamment rétracté dans son logement d'accueil pour ne pas bloquer le coulissement complet des languettes d'assemblages 11 dans leurs logements complémentaires aménagés dans le châssis.

Comme déjà exposé précédemment lors de la description des moyens d'assemblage, si la réglette de verrouillage a été correctement assemblée sur le châssis, l'orifice de sortie de l'ergot de verrouillage (autrement dit, l'orifice du logement d'accueil précité) se trouve aligné avec un orifice de verrouillage 24 présent à l'arrière du châssis. La position de verrouillage peut alors être mise en œuvre.

Dans cette position de verrouillage, l'extrémité de verrouillage 135 de l'ergot 131 fait saillie vers l'extérieur de la face interne de la réglette de verrouillage (c'est à dire vers l'extérieur de la face interne de l'unité de verrouillage 13). Cette extrémité de verrouillage 135 (ainsi éventuellement qu'une partie de la tige de l'ergot de verrouillage 131) pénètre alors dans l'orifice de verrouillage complémentaire 24 du châssis. L'ergot de verrouillage 131 s'oppose alors au désassemblage de la réglette de verrouillage et du châssis.

On peut donc assimiler l'ergot de verrouillage 131 à un verrou rétractile.

Selon une caractéristique particulière, l'extrémité de verrouillage 135 de l'ergot de verrouillage 131 prend la forme d'un crochet en « T » (comme illustré sur la figure 1). Par exemple, l'extrémité de verrouillage peut prendre la forme d'un crochet de type Kensington™. De cette manière, la réglette de verrouillage est rendue compatible avec un châssis existant qui disposerait déjà d'une fente de verrouillage au format standard Kensington™. Il convient par ailleurs de noter qu'une simple translation de l'ergot de verrouillage 131 dans l'axe de sa tige suffit à assurer le verrouillage ou le déverrouillage de la réglette, du moment que l'extrémité de verrouillage 135 est correctement orientée pour franchir l'orifice de verrouillage 24 du châssis. Néanmoins, selon une autre caractéristique particulière, ce mouvement de translation peut être accompagné ou complété par un mouvement de rotation autour de l'axe de la tige de l'ergot, notamment une fois que l'extrémité de verrouillage 135 a complétement franchi l'orifice de verrouillage 24 du châssis, et qu'elle se trouve donc à l'intérieur du châssis. Une telle rotation a un sens quand l'orifice de verrouillage 24 du châssis n'est pas circulaire, mais a la forme d'une fente par exemple. Elle permet alors de renforcer encore le verrouillage de la réglette, en rendant plus difficile toute tentative visant à casser ou à arracher l'unité de verrouillage 13. En effet, l'orientation de l'extrémité de verrouillage 135 ne permet alors plus son extraction par simple translation, car la barre supérieure du « T » formé par l'extrémité de verrouillage 135 vient en butée contre la face interne de la façade arrière 22 du châssis, empêchant le franchissement de l'orifice de verrouillage 24.

Les moyens de verrouillage comprennent également des moyens d'entrainement 132 de l'ergot de verrouillage mobile 131, visibles par exemple sur les figures 5a et 5c. Ces moyens d'entrainement, lorsqu'ils sont actionnés par l'utilisateur, entrainent la mise en mouvement de l'ergot de verrouillage 131. Plus particulièrement, en fonction d'un sens dans lequel ils sont actionnés, ces moyens d'entrainement entrainent l'ergot de verrouillage de sa position de verrouillage à sa position de déverrouillage, ou inversement.

Dans un mode de réalisation particulier, ces moyens d'entrainement 132 sont accessibles sur la face externe de la réglette de verrouillage, et plus particulièrement sur une face externe de l'unité de verrouillage 13. Selon une caractéristique particulière, un outil spécifique (tel que l'outil 3 visible sur la figure 5b) peut être requis pour actionner ces moyens d'entrainement 132. Un tel outil spécifique peut notamment prendre la forme d'une clé mise à disposition de la personne habilitée à verrouiller ou déverrouiller la réglette de verrouillage.

Dans un mode de réalisation particulier, les moyens d'entrainement 132 font saillie vers l'extérieur de la face externe de l'unité de verrouillage 13 dans la position de déverrouillage précédemment décrite, et sont au contraire disposés au sein d'un logement d'accueil aménagé dans l'unité de verrouillage 13 dans la position de verrouillage précédemment décrite. Ainsi, l'utilisateur est en mesure d'évaluer très rapidement, d'un simple coup d'œil, si la réglette de verrouillage est verrouillée (les moyens d'entrainement 132 sont alors rétractés dans leur logement, comme présenté sur la figure 5c) ou déverrouillée (les moyens d'entrainement 132 sont alors sortis de leur logement et font saillie vers l'extérieur de l'unité de verrouillage 13, comme présenté sur la figure 5a). Cette indication visuelle vient avantageusement compléter des indications visuelles plus classiques mais parfois moins visibles, comme par exemple des pictogrammes éventuellement inscrits sur l'unité de verrouillage au regard de chaque position. Ainsi, le risque que l'utilisateur imagine la réglette verrouillée alors qu'elle ne l'est pas en réalité pas est limité.

Dans un mode de réalisation particulier, l'unité de verrouillage comprend également un point d'ancrage. Un tel point d'ancrage permet de fixer la réglette de verrouillage à un élément fixe du bâti, par exemple au moyen d'un câble de sécurité muni d'un verrou idoine. Ce point d'ancrage fait office de moyen de sur-verrouillage, dans la mesure où il autorise un verrouillage complémentaire au verrouillage de la réglette au châssis, en permettant de sécuriser l'ensemble formé par un dispositif numérique tactile retenu dans son châssis verrouillé par une réglette de verrouillage. Un tel verrouillage complémentaire peut notamment s'avérer intéressant lorsque le châssis n'est pas amené à être fixé de manière pérenne à un socle fixe.

Ce point d'ancrage peut prendre différentes formes, comme par exemple celle d'un anneau. Dans le mode de réalisation illustré par les figures 4 à 6, le point d'ancrage prend la forme d'une fente de verrouillage 134 adaptée pour accueillir un verrou idoine. Selon une caractéristique particulière, cette fente de verrouillage 134 est une encoche de sécurité de type Kensington™, qui répond à des spécifications précises quant à ses dimensions et au type de métal qui peut être utilisé comme renfort. De cette manière, le sur-verrouillage - autrement dit la sécurisation de la réglette de verrouillage mise en œuvre au moyen de cette fente de verrouillage - peut être réalisé en utilisant un type de verrou largement reconnu pour sa fiabilité et couramment disponible dans le commerce.

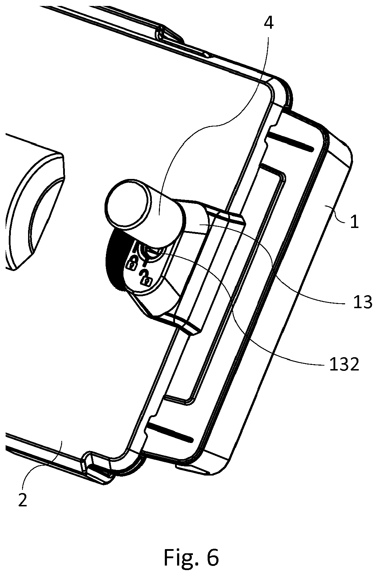

Dans un mode de réalisation particulier, les moyens d'entrainement 132 de l'ergot de verrouillage 131 sont positionnés de manière à être partiellement recouverts par un dispositif de verrouillage qui prendrait place dans la fente de verrouillage 134. Les moyens d'entrainement 132 et la fente de verrouillage 134 sont par exemple disposés sur une même face de l'unité de verrouillage 13, et distants l'un par rapport à l'autre d'une distance telle que le corps d'un verrou du commerce de dimensions standard adapté à prendre place dans la fente de verrouillage 134, une fois verrouillé dans cette fente, recouvre suffisamment les moyens d'entrainement 132 pour empêcher leur actionnement. Selon une caractéristique particulière, lorsque la fente de verrouillage 134 est une encoche de sécurité de type Kensington™, les moyens d'entrainement 132 et la fente de verrouillage 134 sont distants l'un par rapport à l'autre d'au maximum neuf millimètres (distance centre à centre) : on s'assure ainsi que le corps cylindrique d'un verrou Kensington™, dont le diamètre est standardisé (19,1 millimètres), viendra recouvrir au moins partiellement les moyens d'entrainement une fois le verrou engagé dans la fente de verrouillage 134. Une telle configuration est par exemple illustrée par la **figure 6****,** sur laquelle il apparaît que les moyens d'entrainement 132 sont partiellement recouverts par le corps 4 d'un verrou fixé au point d'ancrage 134 de l'unité de verrouillage (le câble de sécurité reliant ce verrou au bâti n'est pas représenté sur la figure 6).

Une telle configuration présente de nombreux avantages. En particulier, le corps 4 du verrou empêche tout actionnement des moyens d'entrainement 132 de l'ergot de verrouillage mobile. Il est donc nécessaire de retirer ce verrou 4 pour pouvoir actionner les moyens d'entrainement de l'ergot de verrouillage, et être en mesure de déverrouiller la réglette de verrouillage. La protection du dispositif numérique contre le vol est donc encore renforcée.

Par ailleurs, il est particulièrement intéressant de combiner ce mode de réalisation avec celui décrit précédemment, dans lequel les moyens d'entrainement 132 font saillie vers l'extérieur de l'unité de verrouillage en position de déverrouillage et sont rétractés dans l'unité de verrouillage en position de verrouillage. En effet, dans cette situation, le sur-verrouillage de la réglette au niveau de la fente de verrouillage 134 ne peut être mise en œuvre tant que la réglette de verrouillage n'est pas dans la position de verrouillage : tant que cette position n'est pas atteinte, les moyens d'entrainement 132 forment en effet une protubérance qui s'étend vers l'extérieur de l'unité de verrouillage, et qui empêche la fixation d'un verrou dans la fente de verrouillage 134. Le risque que l'utilisateur oublie de verrouiller la réglette de verrouillage au châssis est alors grandement limité, voire quasi-inexistant, dès lors que l'utilisateur utilise la fente de verrouillage 134 comme moyen de sur-verrouillage : il est en effet peu probable qu'un utilisateur oublie à la fois de verrouiller la réglette de verrouillage au châssis, et de surverrouiller la réglette de verrouillage au bâti.

Les caractéristiques présentées dans les différents modes de réalisation décrits précédemment sont bien entendues combinables entre-elles, sans sortir du cadre de l'invention.

### 5.3. Système de verrouillage

Selon un autre aspect, l'invention se rapporte également à un système de verrouillage d'un dispositif numérique. Un tel système comprend d'une part un châssis adapté pour recevoir un dispositif numérique, et d'autre part une réglette de verrouillage telle que présentée précédemment. Le châssis comprend au moins un orifice de verrouillage, par exemple une fente de verrouillage au format standard telle que la fente 24 visible sur la figure 3. Un exemple d'un tel châssis a déjà été présenté lors de la description du principe général de la réglette de verrouillage. Les moyens de verrouillage de la réglette au châssis, présents sur la réglette, sont configurés pour permettre un verrouillage de la réglette au niveau de l'orifice de verrouillage du châssis, une fois la réglette de verrouillage assemblée au châssis. Par exemple, l'ergot de verrouillage et son extrémité de verrouillage sont conformés et dimensionnés de manière à pouvoir s'insérer dans l'orifice de verrouillage du châssis, lorsque la réglette de verrouillage est complètement assemblée sur le châssis.

Dans un mode de réalisation particulier, le châssis comprend des moyens d'assemblage complémentaires aux moyens d'assemblage de la réglette de verrouillage. Par exemple, le châssis comprend des logements destinés à recevoir des languettes d'assemblage présentes sur la réglette de verrouillage (les orifices d'entrée 25 de tels logements sont par exemple visibles sur la figure 3). Il convient cependant de noter que la présence, dans le châssis, de moyens d'assemblage complémentaires aux moyens d'assemblage de la réglette de verrouillage, n'est pas une caractéristique limitative du système de verrouillage selon la technique proposée. En effet, dans un autre mode de réalisation, le châssis ne comprend pas de tels moyens d'assemblage complémentaire, et ce sont les moyens d'assemblage présents sur la réglette de verrouillage qui assurent seuls l'assemblage de la réglette sur le châssis (par exemple, les moyens d'assemblage de la réglette peuvent prendre la forme d'au moins une rainure, dans laquelle un côté du châssis vient prendre place lorsque la réglette est montée sur le châssis : le châssis ne dispose alors pas de moyens complémentaires spécifiquement prévus pour l'assemblage d'une réglette de verrouillage).

Dans un mode de réalisation particulier, le châssis comprend en outre :
- au moins un moyen de maintien mobile du dispositif numérique ;
- des moyens de blocage dudit au moins un moyen de maintien mobile dans une position prédéterminée, lesdits moyens de blocages étant actifs lorsqu'un ergot de verrouillage est inséré dans l'orifice de verrouillage dudit châssis.

Un tel mode de réalisation est par exemple illustré en relation avec la **figure 7**, qui présente un châssis 2 vu de devant, mais dont la façade avant a été retirée pour révéler l'intérieur du châssis. Le principe de ce mode de réalisation a déjà été partiellement décrit lors de la présentation générale d'un exemple de châssis : la rainure 23A est un moyen de maintien mobile du dispositif numérique, dont la position peut être ajustée et bloquée postérieurement à l'installation du dispositif numérique au sein du châssis 2, de manière à ce que les rainures 23A et 23C en vis-à-vis enserrent le dispositif numérique et rendent difficile son extraction. On s'intéresse maintenant aux moyens permettant de bloquer la position de cette rainure 23A. Dans le mode de réalisation particulier illustré en figure 7, la paroi arrière de la rainure mobile 23A s'étend sous forme de crémaillères (23A-C1, 23A-C2) au sein du châssis 2. Des verrous de crémaillère (28-1, 28-2) sont solidaires d'une plaque mobile 29 disposée au sein du châssis 2, et supportant le bouton 26 (visible sur la figure 3). La plaque mobile 29 et les verrous de crémaillère (28-1, 28-2) forment ensemble des moyens de blocage permettant de bloquer la position de la rainure 23A dans une position déterminée. Lorsqu'un utilisateur actionne le bouton 26, la plaque mobile 29 se déplace et les verrous de crémaillère (28-1, 28-2) libèrent les crémaillères (23A-C1, 23A-C2) : la rainure 23A peut alors être déplacée.

Lorsque le bouton 26 n'est pas actionné, des moyens de rappel élastique maintiennent le bouton 26, la plaque mobile 29 et les verrous de crémaillère (28-1, 28-2) dans une position de blocage des crémaillères (23A-C1, 23A-C2). Dans cette configuration, un orifice de verrouillage 291 présent sur la plaque mobile 29 se retrouve en vis-à-vis de l'orifice de verrouillage 24 du châssis. De cette manière, un ergot de verrouillage inséré dans l'orifice de verrouillage 24 du châssis traverse également l'orifice de verrouillage 291 de la plaque mobile 29, s'opposant alors au déplacement de cette plaque 29 au sein du châssis 2. Tant que cet ergot de verrouillage n'est pas retiré, la position de la rainure 23A est donc bloquée, et le bouton 26 ne peut être actionné. Par ce mécanisme, le châssis 2 présente donc par lui-même des moyens de sécurisation du dispositif numérique qui y est installé, qui peuvent être mis en œuvre dès lors que l'orifice de verrouillage 24 du châssis est utilisé. Comme le verrouillage d'une réglette de verrouillage sur un châssis repose justement sur l'utilisation de cet orifice de verrouillage 24, ces moyens de sécurisation propres au châssis sont automatiquement mis en œuvre dès lors qu'une réglette de verrouillage est assemblée sur le châssis. L'utilisation d'une réglette de verrouillage, telle que proposée, permet donc de combiner les moyens de sécurisation du dispositif numérique installé dans le châssis. Le niveau de sécurisation de ce dispositif numérique est donc encore amélioré.

Selon une caractéristique particulière, pour renforcer encore ce niveau de sécurisation, le corps de l'unité de verrouillage de la réglette peut être conformé et dimensionné de manière à bloquer la course du bouton 26, lorsque la réglette de verrouillage est montée sur le châssis. Cette situation est par exemple illustrée sur la figure 5c : le corps 133 de l'unité de verrouillage 13 vient en butée contre le bouton 26, lui supprimant toute latitude de déplacement. La course du bouton 26 est donc doublement bloquée, d'une part par l'ergot de verrouillage 131 de la réglette qui empêche tout déplacement de la plaque mobile 29 et donc du bouton 26 qu'elle supporte, et d'autre part par le corps 113 de l'unité de verrouillage 13 qui fait obstacle au déplacement du bouton 26.

### 5.4. Procédé de verrouillage

Selon un autre aspect, on décrit également un procédé de verrouillage d'un dispositif numérique au sein d'un châssis. On décrit, en relation avec la **figure 8****,** les principales étapes mises en œuvre par l'utilisateur pour réaliser un tel verrouillage, dans un mode de réalisation particulier.

Lors d'une première étape 81, le dispositif numérique est inséré au sein du châssis, par exemple par un côté libre du châssis (autrement dit, par un côté dépourvu de moyens de maintien). Une fois le dispositif numérique complètement introduit dans le châssis, il est possible, si un moyen des moyens de maintien présents sur le châssis est mobile, et prend par exemple la forme d'une rainure mobile telle que décrite précédemment, d'abaisser cette rainure mobile de sorte à venir enserrer le dispositif numérique. On met ainsi en œuvre un premier niveau de sécurisation au niveau du châssis : les forces de frottement exercées sur les côtés du dispositif numérique s'opposent à son extraction hors du châssis.

On effectue ensuite, dans une étape 82, l'assemblage d'une réglette de verrouillage, précédemment décrite, sur ledit châssis. A cet effet, on introduit par exemple des languettes d'assemblage de la réglette de verrouillage dans des logements complémentaires du châssis, jusqu'à un point de clipsage indiquant que la réglette de verrouillage est correctement assemblée : à ce point, les moyens de retenue de la réglette de verrouillage retienne le dispositif numérique dans le châssis, et l'orifice d'entrée du logement d'accueil de l'ergot de verrouillage (aménagé dans l'unité de verrouillage de la réglette de verrouillage) se trouve en vis-à-vis avec un orifice de verrouillage présent au dos du châssis.

On procède alors au verrouillage de la réglette au châssis, dans une étape 83. Cette étape consiste à actionner, éventuellement au moyen d'un outil spécifique, les moyens d'entrainement de l'ergot de verrouillage mobile de la réglette de verrouillage. L'ergot de verrouillage est alors entrainé jusqu'à sa position de verrouillage : son extrémité de verrouillage fait saillie hors de l'unité de verrouillage et pénètre dans l'orifice de verrouillage complémentaire du châssis. Cette configuration correspond à un deuxième niveau de sécurisation : la réglette de verrouillage vient fermer le côté libre du châssis et s'opposer au retrait du dispositif numérique, et elle ne peut être démontée (c'est à dire désolidarisée du châssis) tant que les moyens d'entrainement de l'ergot de verrouillage n'auront pas été actionnés dans l'autre sens.

Optionnellement, dans une étape supplémentaire 84, on procède à un sur-verrouillage de la réglette : le point d'ancrage présent sur l'unité de verrouillage est alors utilisé pour fixer l'ensemble formé par le châssis, la réglette de verrouillage et le dispositif numérique à un élément fixe du bâti, par exemple au moyen d'un câble de sécurité muni d'un verrou idoine. Le corps de ce verrou vient alors, dans un mode de réalisation particulier de la technique proposé, recouvrir les moyens d'entrainement de l'ergot de verrouillage, renforçant de cette manière encore un peu plus le niveau de sécurité offert par l'ensemble du système.

## Revendications

1. Réglette de verrouillage (1), destinée à verrouiller un dispositif numérique préalablement inséré dans un châssis (2), ladite réglette (1) comprenant une face interne de réception d'au moins une portion dudit dispositif numérique et une face externe de verrouillage, ladite réglette comprenant:
- des moyens d'assemblage (11) sur ledit châssis ;
- des moyens de retenue (12) dudit dispositif numérique ;
- au moins une unité de verrouillage (13), comprenant des moyens de verrouillage (131, 132) de la réglette audit châssis,
la réglette étant **caractérisée en ce que** l'unité de verrouillage (13) comprend un point d'ancrage (134) prenant la forme d'une fente de verrouillage adaptée pour accueillir un verrou idoine.

2. Réglette de verrouillage selon la revendication 1, **caractérisée en ce que** lesdits moyens de verrouillage comprennent un ergot de verrouillage mobile (131) disposant d'une extrémité de verrouillage (135), ledit ergot de verrouillage étant mobile entre deux positions :
- une position de déverrouillage, dans laquelle ledit ergot (131) est au moins partiellement disposé au sein d'un logement d'accueil aménagé dans ladite unité de verrouillage (13) ;
- une position de verrouillage, dans laquelle ladite extrémité de verrouillage (135) dudit ergot (131) fait saillie vers l'extérieur de la face interne de ladite réglette.

3. Réglette de verrouillage selon la revendication 2, **caractérisée en ce que** lesdits moyens de verrouillage comprennent des moyens d'entrainement (132) dudit ergot de verrouillage mobile (131) de ladite position de verrouillage à ladite position de déverrouillage et inversement.

4. Réglette de verrouillage selon la revendication 2, **caractérisée en ce que** ladite extrémité de verrouillage dudit ergot de verrouillage mobile (131) prend la forme d'un crochet en « T ».

5. Réglette de verrouillage selon la revendication 3, **caractérisée en ce que** lesdits moyens d'entrainement (132) :
- font saillie vers l'extérieur de la face externe de ladite réglette, au niveau de ladite unité de verrouillage, dans ladite position de déverrouillage ;
- sont disposés au sein d'un logement d'accueil aménagé dans ladite unité de verrouillage (13), dans ladite position de verrouillage.

6. Réglette de verrouillage selon la revendication 3, **caractérisée en ce que**, en position de verrouillage, lesdits moyens d'entrainement (132) sont au moins partiellement recouverts par un dispositif de verrouillage qui peut prendre place dans ladite fente de verrouillage (134).

7. Réglette de verrouillage selon la revendication 6, **caractérisée en ce que** lesdits moyens d'entrainement (132) et ladite fente de verrouillage (134) sont disposés sur une même face de ladite unité de verrouillage, et distants l'un par rapport à l'autre d'au maximum neuf millimètres.

8. Système de verrouillage d'un dispositif numérique, **caractérisé en ce qu'**il comprend :
- un châssis adapté pour recevoir ledit dispositif numérique, ledit châssis comprenant au moins un orifice de verrouillage ;
- une réglette de verrouillage selon l'une quelconque des revendications 1 à 7, les moyens de verrouillage de ladite réglette étant configurés pour permettre le verrouillage de ladite réglette au châssis, au niveau de l'orifice de verrouillage dudit châssis, lorsque ladite réglette est assemblée audit châssis.

9. Système de verrouillage d'un dispositif numérique selon la revendication 8, **caractérisé en ce que** ledit châssis comprend en outre :
- au moins un moyen de maintien mobile du dispositif numérique ;
- des moyens de blocage dudit au moins un moyen de maintien mobile dans une position prédéterminée, lesdits moyens de blocage étant actifs lorsqu'un ergot de verrouillage est inséré dans l'orifice de verrouillage dudit châssis.

10. Procédé de verrouillage d'un dispositif numérique au sein d'un châssis, ledit procédé étant **caractérisé en ce qu'**il comprend :
- une étape d'insertion dudit dispositif numérique au sein dudit châssis ;
- une étape d'assemblage, audit châssis, d'une réglette de verrouillage selon l'une quelconque des revendications 1 à 7 ;
- une étape de verrouillage de ladite réglette audit châssis, comprenant une étape d'actionnement des moyens d'entrainement de l'ergot de verrouillage mobile de la réglette, au moyen d'un outil spécifique.

11. Procédé de verrouillage selon la revendication 10, **caractérisé en ce qu'**il comprend en outre, postérieurement à l'étape de verrouillage de ladite réglette audit châssis, une étape de sur-verrouillage comprenant une étape de fixation d'un verrou au point d'ancrage présent sur l'unité de verrouillage de la réglette.

## Patentansprüche

1. Verriegelungsleiste (1), die dazu bestimmt ist, eine digitale Vorrichtung, die zuvor in einen Rahmen (2) eingesetzt ist, zu verriegeln, wobei die Leiste (1) eine Innenfläche zum Aufnehmen mindestens eines Abschnitts der digitalen Vorrichtung und eine äußere Verriegelungsfläche aufweist, wobei die Leiste aufweist:
- Mittel zum Montieren (11) auf dem Rahmen;
- Mittel zum Halten (12) der digitalen Vorrichtung;
- mindestens eine Verriegelungseinheit (13), die Mittel zum Verriegeln (131, 132) der Leiste an dem Rahmen aufweist,
wobei die Leiste **dadurch gekennzeichnet ist, dass** die Verriegelungseinheit (13) einen Verankerungspunkt (134) aufweist, der die Form eines Verriegelungsschlitzes annimmt, der geeignet ist, um einen entsprechenden Riegel aufzunehmen.

2. Verriegelungsleiste nach Anspruch 1, **dadurch gekennzeichnet, dass** die Verriegelungsmittel einen beweglichen Verriegelungssporn (131) aufweisen, der über ein Verriegelungsende (135) verfügt, wobei der Verriegelungssporn zwischen zwei Positionen beweglich ist:
- einer Entriegelungsposition, in der der Sporn (131) mindestens teilweise in einem Aufnahmegehäuse angeordnet ist, das in der Verriegelungseinheit (13) ausgebildet ist;
- einer Verriegelungsposition, in der das Verriegelungsende (135) des Sporns (131) von der Innenfläche der Leiste nach außen hervorsteht.

3. Verriegelungsleiste nach Anspruch 2, **dadurch gekennzeichnet, dass** die Verriegelungsmittel Mitnahmemittel (132) des beweglichen Verriegelungssporns (131) von der Verriegelungsposition in die Entriegelungsposition und umgekehrt aufweisen.

4. Verriegelungsleiste nach Anspruch 2, **dadurch gekennzeichnet, dass** das Verriegelungsende des beweglichen Verriegelungssporns (131) die Form eines "T"-Hakens annimmt.

5. Verriegelungsleiste nach Anspruch 3, **dadurch gekennzeichnet, dass** die Mitnahmemittel (132):
- von der Außenfläche der Leiste auf Ebene der Verriegelungseinheit in der Verriegelungsposition nach außen hervorstehen;
- in einem Aufnahmegehäuse, das in der Verriegelungseinheit (13) ausgebildet ist, in der Verriegelungsposition angeordnet sind.

6. Verriegelungsleiste nach Anspruch 3, **dadurch gekennzeichnet, dass** die Mitnahmemittel (132) mindestens teilweise von einer Verriegelungsvorrichtung bedeckt sind, die in dem Verriegelungsschlitz (134) positioniert werden kann.

7. Verriegelungsleiste nach Anspruch 6, **dadurch gekennzeichnet, dass** die Mitnahmemittel (132) und der Verriegelungsschlitz (134) auf einer gleichen Seite der Verriegelungseinheit und in einem Abstand von höchstens neun Millimetern voneinander angeordnet sind.

8. Verriegelungssystem einer digitalen Vorrichtung, **dadurch gekennzeichnet ist, dass** es aufweist:
- einen Rahmen, der geeignet ist, um die digitale Vorrichtung aufzunehmen, wobei der Rahmen mindestens eine Verriegelungsöffnung aufweist;
- eine Verriegelungsleiste nach einem der Ansprüche 1 bis 7, wobei die Verriegelungsmittel der Leiste konfiguriert sind, um das Verriegeln der Leiste an dem Rahmen auf Ebene der Verriegelungsöffnung des Rahmens zu ermöglichen, wenn die Leiste an dem Rahmen befestigt ist.

9. Verriegelungssystem einer digitalen Vorrichtung nach Anspruch 8, **dadurch gekennzeichnet ist, dass** der Rahmen ferner aufweist:
- mindestens ein bewegliches Haltemittel der digitalen Vorrichtung;
- Blockiermittel des mindestens einen beweglichen Haltemittels in einer vorbestimmten Position, wobei die Blockiermittel aktiv sind, wenn ein Verriegelungssporn in der Verriegelungsöffnung des Rahmens eingefügt ist.

10. Verriegelungsverfahren einer digitalen Vorrichtung in einem Rahmen, wobei das Verfahren **dadurch gekennzeichnet ist, dass** es aufweist:
- einen Schritt des Einfügens der digitalen Vorrichtung in den Rahmen;
- einen Schritt des Montierens einer Verriegelungsleiste nach einem der Ansprüche 1 bis 7 an dem Rahmen;
- einen Schritt des Verriegelns der Verriegelungsleiste an dem Rahmen, umfassend einen Schritt des Betätigens der Mitnahmemittel des beweglichen Verriegelungssporns der Leiste mit Hilfe eines spezifischen Werkzeugs.

11. Verriegelungsverfahren nach Anspruch 10, **dadurch gekennzeichnet, dass** es ferner nach dem Schritt des Verriegelns der Leiste an dem Rahmen einen Überverriegelungsschritt aufweist, der einen Schritt des Befestigens eines Schlosses an dem Verankerungspunkt, der sich auf der Verriegelungseinheit der Leiste befindet, aufweist.

## Claims

1. Locking bracket (1) for locking a digital device preliminarily inserted into a casing (2), said bracket (1) comprising an internal face for receiving at least one portion of said digital device and one external locking face, said bracket comprising:
- means of assembling (11) with said casing;
- means for retaining (12) said digital device;
- at least one locking unit (13) comprising means for locking (131, 132) the bracket to said casing
the bracket being **characterized in that** the locking unit (13) comprises an anchor point (134) taking the form of a locking slot adapted to receive an appropriate lock.

2. Locking bracket according to claim 1, **characterized in that** said locking means comprise a mobile locking pin (131) having available a locking extremity (135), the locking pin being mobile between two positions:
- an unlocked position, in which said pin (131) is at least partially disposed within a receiving recess made in said locking unit (13);
- a locked position in which said locking extremity (135) of said pin (131) protrudes outwards from the internal face of said bracket.

3. Locking bracket according to claim 2, **characterized in that** said locking means comprise means for driving (132) said mobile locking pin (131) from said locked position to said unlocked position and vice versa.

4. Locking bracket according to claim 2, **characterized in that** said locking extremity of said mobile locking pin (131) takes the form of a T-shaped hook.

5. Locking bracket according to claim 3, **characterized in that** said means for driving (132):
- protrude outwards from the external face of said locking bracket, at the locking unit, in said unlocked position;
- are disposed within a receiving recess made in said locking unit (13) in said locked position.

6. Locking bracket according to claim 3, **characterized in that**, in the locked position, said driving means (132) are at least partially covered by a locking device that can take position in said locking slot (134).

7. Locking bracket according to claim 6, **characterized in that** said said driving means (132) and said locking slot (134) are disposed on a same face of said locking unit and are distant from each other by a maximum of nine millimeters.

8. System for locking a digital device **characterized in that** it comprises:
- a casing adapted to receiving said digital device, said casing comprising at least one locking hole;
- a locking bracket according to any one of the claims 1 to 7, the means for locking said bracket being configured to enable the locking of said bracket to the casing, at the locking hole of said casing, when the bracket is assembled with said casing.

9. System for locking a digital device according to claim 8, **characterized in that** said casing further comprises:
- at least one mobile holding means for holding the digital device;
- means for blocking said at least one mobile holding means in a predetermined position, said blocking means being active when a locking pin is inserted into the locking hole of said casing.

10. Method for locking a digital device within a casing, said method being **characterized in that** it comprises:
- a step for inserting said digital device into said casing;
- a step for assembling, with said casing, a locking bracket according to any one of the claims 1 to 7;
- a step for locking said bracket to said casing, comprising a step for actuating means for driving the mobile locking pin of the bracket, by means of a specific tool.

11. Method for locking according to claim 10, **characterized in that** it further comprises, subsequently to the step of locking said bracket to said casing, a step for providing an additional locking cover for the bracket, comprising a step for affixing a lock to the anchor point present on the locking unit of the bracket.
